# EUROPÄISCHE PATENTANMELDUNG

(11) **EP 1 437 929 A2**
(43) Veröffentlichungstag der Anmeldung: **14.07.2004**
(21) Anmeldenummer: 04000303.0
(22) Anmeldetag: 09.01.2004
(51) Int. Cl.: H05K 5/04

(54) **Gehäuse aus Aluminium-Profilen zur Aufnahme elektrischer und elektronischer Bauteile**

(30) Priorität: 09.01.2003 DE 10300418
(71) Anmelder: Palima W. Ludwig & Co., 6060 Sarnen (CH)
(72) Erfinder: Späth, Walter E., 78224 Überlingen a. Ried (DE)
(74) Vertreter: Riebling, Peter, Dr.-Ing.

(57) **Zusammenfassung**

Es wird ein Gehäuse aus Aluminium-Profilen zur Aufnahme elektrischer und elektronischer Bauteile, mit die Außenwand bildenden Kastenhohlprofilen beschrieben, die im Eckbereich über Verbindungsstege miteinander verbunden sind. Zur leichten Montage des Gehäuses ist vorgesehen, dass mindestens die beiden Seitenwandprofile, das Rückwandprofil und das Frontprofil über zugeordnete Eckverbinder steckbar miteinander verbunden sind.

## Beschreibung

Die Erfindung betrifft ein Gehäuse aus Aluminium-Profilen zur Aufnahme elektrischer und elektronischer Bauteile nach dem Oberbegriff des Patentanspruches 1.

Mit dem Gegenstand der EP 0262450 A2 ist ein Mehrzweck-Tischgehäuse bekannt geworden, das aus zwei gleichen Seitenteilen, einem Oberteil und einem Unterteil zusammengesetzt ist und Vorrichtungen zum Einbau von Baugruppenträgern, Leiterplatten-Tragleisten und Einschub-Gleitschienen aufnimmt. Mindestens die Seitenteile bestehen aus einem Kastenhohlprofil, das nach innen gerichtete Verbindungsstege zur Verbindung mit im Innenraum angeordneten Profilleisten aufweist.

Dieses Mehrzweck-Tischgehäuse ist jedoch nicht ohne weiteres zerlegbar und dient im wesentlichen nur der Aufnahme von Baugruppenträgern und Leiterplatten-Tragleisten bei Schaltschränken.

Das Tischgehäuse ist jedoch nicht als eigenständiges Rechnergehäuse geeignet, weil es nicht möglich ist, die einzelnen Hohlprofile zu einem in sich geschlossenem Gehäuse zusammenzusetzen.

Der Erfindung liegt deshalb die Aufgabe zugrunde, ein Gehäuse der eingangs genannten Art so weiterzubilden, dass ein in sich geschlossenes Rechnergehäuse geschaffen wird, das leicht zusammensetzbar ist und ein universell verwendbares Profil verwendet.

Dadurch ergibt sich erstmals die Möglichkeit, entsprechend der Wahl des Profils unterschiedlich große Rechnergehäuse vollkommen dicht und ästhetisch ansprechend zusammenzusetzen.

Zur Lösung der gestellten Aufgabe ist die Erfindung dadurch gekennzeichnet, dass mindestens die beiden Seitenwandprofile, das Rückwandprofil und das Frontprofil aus Aluminium-Hohlprofilen bestehen, die jeweils über zugeordnete Eckverbinder steckbar miteinander zusammen verbunden sind.

Damit ergibt sich der Vorteil, dass man mit zwei im wesentlichen gleichgeformten Hauptprofilen (für das Frontprofil und die Seitenwandprofile) ein vielgestaltiges Gehäuse herstellen kann, weil diese Profilarten auf unterschiedliche Weise zusammengesteckt werden können und ein in sich geschlossenes Gehäuse ergeben.

Je nach Ausbildung der Eckverbinder ist es vorgesehen, dass die Eckverbinder außen angeordnet sind und als Stilelement wirken und gleichzeitig die Stapelbarkeit einzelner Gehäuse übereinander gewährleisten. In einer anderen Ausgestaltung ist es vorgesehen, dass die Eckverbinder innenliegend angeordnet sind und für den Benutzer nicht sichtbar, die innere Verbindung der insgesamt vier vorhandenen Profile ergeben.

Nach der Erfindung handelt es sich um ein Gehäuse aus multifunktionalen Alu-Profilen zur Aufnahme elektrischer und elektronischer Bauteile, das insbesondere als Rechnergehäuse verwendet werden kann, jedoch auch als Messgerätegehäuse oder als Gehäuse für die Aufnahme von Maschinensteuerungen geeignet ist.

Front- und Seitenwandprofile sind exakt das gleiche Profil! Nur das Rückwandprofil hat eine andere Gestaltung, wobei die Ausbildung zur Eckverbindung innen und außen genau dem anderen Profil (Seitenwand- und Frontprofil) entspricht! Nur so ist es möglich, dass scheinbar total unterschiedliche Profile, an den Ecken sauber zusammenpassen und ein homogenes Design ermöglichen.

Wegen der erfindungsgemäßen Verwendung eines Hohlprofils gibt es dem gemäß eine Innen- und eine Außenschale. Die Gestaltung der Innenschale im Innenbereich nimmt funktionale Aufgaben wahr, während die Außenschale im Außenbereich im wesentlichen Designaufgaben übernimmt.

Der Innenbereich nimmt hierbei:
1. den Boden auf
2. bildet eine Plattform zur Halterung eines kompletten Mainboardes, auf dem sämtliche Rechnerbauteile gehaltert sind und bildet im übrigen
3. einen Aufnahmerahmen mit Anschlagkante für einen darauf aufzusetzenden Deckel.

Die aneinander anstoßenden Profile weisen einen Gehrungsschnitt oder einen Geradschnitt auf. Die Außenseiten der Hohlprofile bleiben frei gestaltbar und man kann entsprechend der gewählten Profilform die Kontur der Außenwand des Hohlprofils anders gestalten als vergleichsweise die Kontur der Innenwand.

Während die Kontur der Innenwand bevorzugt stets gerade bleibt, um eine funktional und technisch einwandfreie Gestaltung des Innenraums zu bilden, kann die nach außen gerichtete Doppelwand des Hohlprofils frei gestaltbar ausgebildet sein.

So kann es bei einer ersten Profilform vorgesehen werden, dass die Außenwand des Hohlprofils konvex ausgebildet ist, um so dem Rechnergehäuse ein formschönes Aussehen zu verleihen, nachdem auf gerade, sichtbare Außenflächen verzichtet wird.

Ein weiterer Vorteil bei der Verwendung von Hohlprofilen ist, dass bei Anordnung schwenkbarer Frontklappen das Profil der Frontklappe dem möglicherweise konvex ausgebildeten Profil der Außenwände angepasst werden kann. Damit ergibt sich ein formschöner Eingriff der Frontklappe in die zugeordnete Ausnehmung im Frontprofil des Gehäuses.

Hierbei ergibt sich der Vorteil, dass die Lagerschalen für die Dreh- oder Schwenklagerung der schwenkbar in einer horizontalen Achse gelagerten Frontplatte im Innenraum des Hohlprofils angeordnet werden können, so dass die Hohlprofile mehrfach funktionale Aufgaben übernehmen, und unter anderem auch der Lagerung der Frontklappe dienen.

Ferner ergibt sich bei der Ausbildung des Profils als Rückwandprofil der weitere Vorteil, dass die nach außen gerichtete Wandung des Hohlprofils teilweise entfernt werden kann, um damit die Innenwand des Hohlprofils zugänglich zu machen und in dieser Innenwand entsprechende Schlitze anzubringen. So können die Einschubplatinen für das Mainboard versenkt an der Rückwand verankert und deren Steckanschlüsse versenkt in der Rückwand angeordnet werden.

Von besonderem Vorteil ist es, wenn im Innenraum des Hohlprofils die Lageranordnungen für die Schwenklagerung der Frontklappe mehrfach angeordnet sind, so dass sich die Möglichkeit ergibt, unterschiedlich hohe Frontklappen mit unterschiedlichen Profilen - je nach Anwendungszweck und gewünschtem Aussehen - in dem Hohlprofil zu verankern.

Insgesamt sieht die vorliegende Erfindung beispielsweise vier unterschiedliche Klappenhöhen vor, wobei zwei gleiche und im unterschiedlichen Abstand zueinander angeordnete Lagerschalen im Innenraum des Hohlprofils angeordnet sind.

Es können hierbei für die Ausbildung der Lagerschalen halboffene Kanäle verwendet werden, in die das zugeordnete Rundprofil des Frontprofils als Lagerachse eingeklipst wird.

In einer anderen Ausgestaltung ist es vorgesehen, dass diese Lagerschalen als rund profilierter, geschlossener Kanal ausgebildet sind, wobei die Frontklappe mit entsprechenden Lagerstiften stirnseitig in den rund profilierten Lagerkanal eingreift.

Weiterer Vorteil bei der Verwendung von erfindungsgemäßen Hohlprofilen ist, dass man auch außenseitig (sichtseitig angeordnete) Rastnuten anordnen kann, welche mit der schwenkbaren Seite der Frontklappe zusammen wirken. Im Bereich der jeweiligen Rastnut ist eine entsprechende, horizontal verlaufende Rastnase angeordnet, die mit einer zugeordneten Rastkante an der Frontklappe zusammenwirkt.

Man kann deshalb auf aufwendige Verschlussmechanismen (separat zu montierende Rastverschlüsse) verzichten und ein Gehäuse mit einer schwenkbaren Frontklappe schaffen, deren Verrastung mit Hilfe von Rastprofilen erreicht wird, die direkt in dem Profil des Gehäuses eingearbeitet sind.

Auch die vorher erwähnten Lagerschalen oder rundprofilierten Lagerkanäle sind unmittelbar in das Profil des Hohlprofils (Strangpressprofil) integriert, so dass es ausreicht, ein herkömmliches Strangpressprofil aus einer Aluminium-Leichtmetalllegierung zu verwenden und dieses Profil an die Erfordernisse für das jeweilige Gehäuse anzupassen.
Die Montagefolge zur Herstellung eines derartigen Gehäuses läuft wie folgt ab:
- alle Teile sägen und fräsen
- Gewindebohrungen für Deckel- und Bodenaufnahme schneiden
- in Deckel und Boden Senkbohrungen einbringen
- Seitenprofile über die Eckverbinder verbinden
- Boden einschrauben (hiermit ist die Winkligkeit des Computergehäuses gewährleistet)
- Bodenverschlusskappen in die Eckverbinder eindrücken
- Mainboard einbauen
- Deckel verschrauben
- Deckel-Verschlusskappen in die Eckverbinder eindrücken.

Bei der vorgesehenen Montageart ergibt sich der wesentliche Vorteil, dass das Mainboard auf sehr einfache Weise auf dem umlaufenden inneren Rahmen festgelegt werden kann, denn die vier Profile (Frontprofil, Seitenwand- und

Rückwandprofil) weisen erfindungsgemäß einen umlaufenden, horizontalen Profilansatz auf, der zugeordnete, umlaufende Rippen ausbildet, auf welche das Mainboard aufgesetzt und dort befestigt wird.

Das Mainboard ruht randseitig auf dem umlaufenden Profilansatz und kann deshalb zu Reparaturzwecken sehr einfach aus dem Gehäuse nach oben herausgehoben werden, wodurch die Reparatur durch freie Zugänglichkeit an die Einbaukomponenten sehr stark vereinfacht wird. Es muss hierzu lediglich der Deckel abgeschraubt werden.

Der Zusammenbau des Gehäuses erfolgt völlig werkzeuglos, weil die vorher erwähnten Verschraubungen nur zur Festlegung des Deckels und des Bodens dienen, während die Profile selbst nur durch einfache Steckverbindungen zusammengesteckt werden. Es wird bevorzugt, wenn die verwendeten Eckverbinder Steckstege aufweisen, die mit widerhakenartigen Profilen ausgerüstet sind, so dass ein einmal zusammengestecktes Gehäuse nicht mehr von den Eckverbindern ohne Weiteres gelöst werden kann.
Zusätzlich kann es natürlich auch vorgesehen werden, dass man diese Steckverbindungen zusätzlich mit einem Kleber sichert als nichtlösbare Verbindung oder auch entsprechende Schrauben eindreht, um die Steckverbindung zu arretieren. Dies ist in der Regel aber nicht notwendig.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.
Im Folgenden wird die Erfindung anhand von mehrere Ausführungswege darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: perspektivische Seitenansicht einer ersten Ausführungsform eines Gehäuses
- Figur 2:: Stirnansicht des Gehäuses nach Figur 1
- Figur 3:: perspektivische Draufsicht auf das Gehäuse nach Figur 1
- Figur 4:: perspektivische Darstellung einer ersten Ausführungsform eines Abschlussstopfens
- Figur 5:: perspektivische Darstellung einer zweiten Ausführungsform eines Abschlussstopfens
- Figur 6:: Schnitt durch ein Front- und Seitenwandprofil
- Figur 7:: Schnitt durch ein Profil einer Frontklappe
- Figur 8:: Schnitt durch ein Rückwandprofil
- Figur 9:: Schnitt durch ein Eckverbinder
- Figur 10:: vergrößerte Darstellung eines Stecksteges des Eckverbinders
- Figur 11:: der Eckverbinder nach Figur 9 in perspektivischer Seitenansicht
- Figur 12:: ein gegenüber der Profilform in Figur 6 dargestelltes abgewandeltes Profil eines Front- und Seitenwandprofils
- Figur 13:: eine gegenüber Figur 12 abgewandelte Ausführung eines Profils
- Figur 14:: die Draufsicht auf den Zusammenbau eines Gehäuses nach der Erfindung
- Figur 15:: ein Gehäuse nach Figur 14 in doppelter Ausführung mit zwei übereinander gestapelten Gehäusen
- Figur 16:: schematisiert einen Schnitt durch die Anordnung nach Figur 15
- Figur 17:: eine weitere Ausgestaltung eines Gehäuses mit innenliegenden Eckverbindern

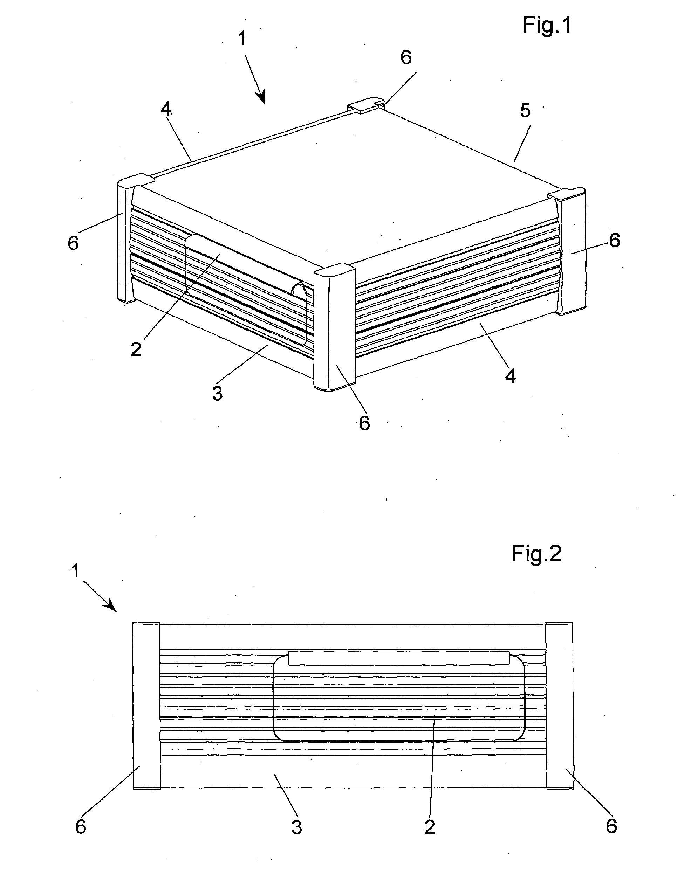

In den Figuren 1 bis 3 ist ein Gehäuse 1 dargestellt, das aus einzelnen Profilen zusammengesetzt ist. Hierbei ist wesentlich, dass ein Frontprofil 3 über Eckverbinder 6 mit zwei Seitenwandprofilen 4 und diese wiederum mit einem Rückwandprofil 5 über die genannten Eckverbinder 6 verbunden ist.

An der Vorderseite des Frontprofils 3 ist eine schwenkbar gelagerte Frontklappe 2 angeordnet, die in einer zugeordneten Ausnehmung des Frontprofils 3 um eine untere, horizontale Achse schwenkbar angeordnet ist.

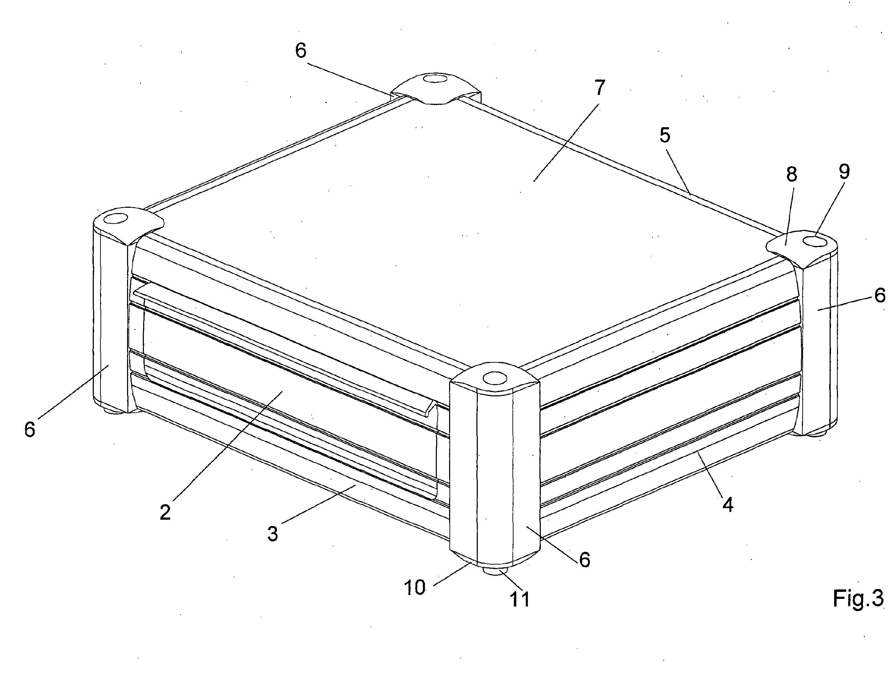

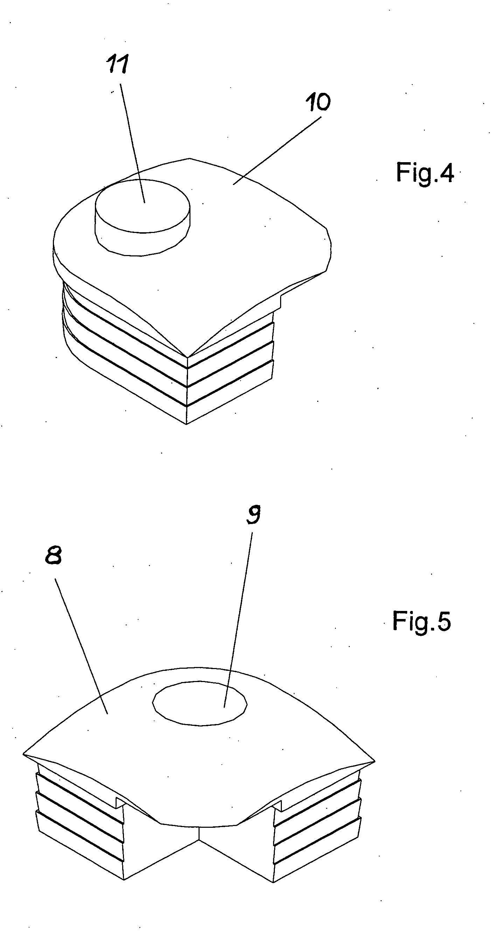

Die Eckverbinder 6 werden nach Figur 3 durch zwei verschiedene Arten von Abschlussstopfen 8, 10 verschlossen, auf welche anhand der Figuren 4 und 5 noch näher eingegangen wird.

Die Figur 4 zeigt einen Abschlussstopfen 10 mit einem daran angeformten Fuß 11, der in das Hohlprofil des Eckverbinders 6 eingesteckt wird und hierbei den fußseitigen Abschluss des Eckverbinders 6 bildet.

Der andere Abschlussstopfen 8 hingegen zeigt eine gleiche Ausführung zum Ausfüllen des Hohlprofils des Eckverbinders 6, wobei jedoch im oberen Bereich eine Ausnehmung 9 angeordnet ist.

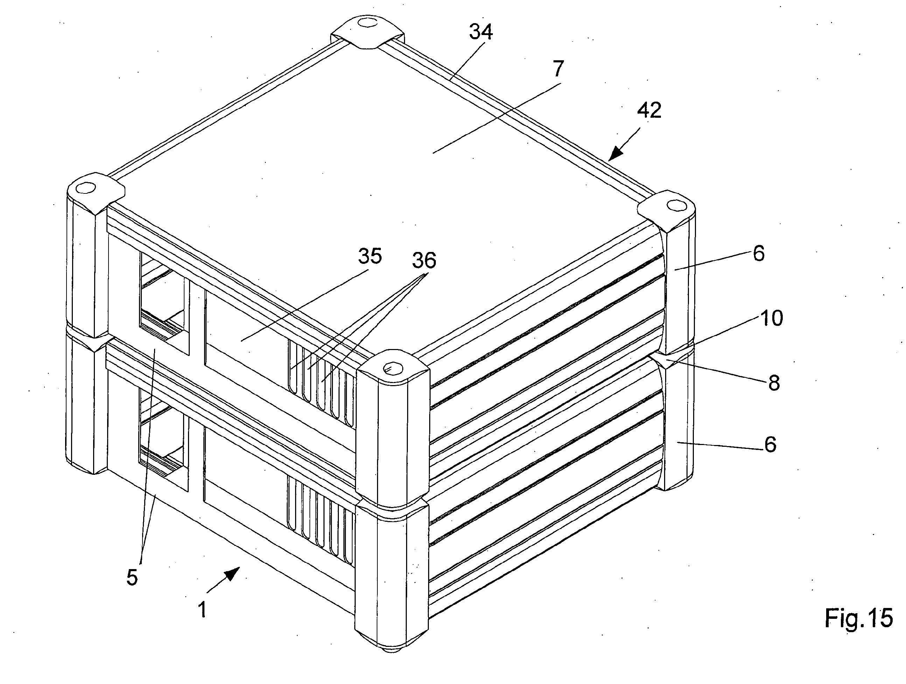

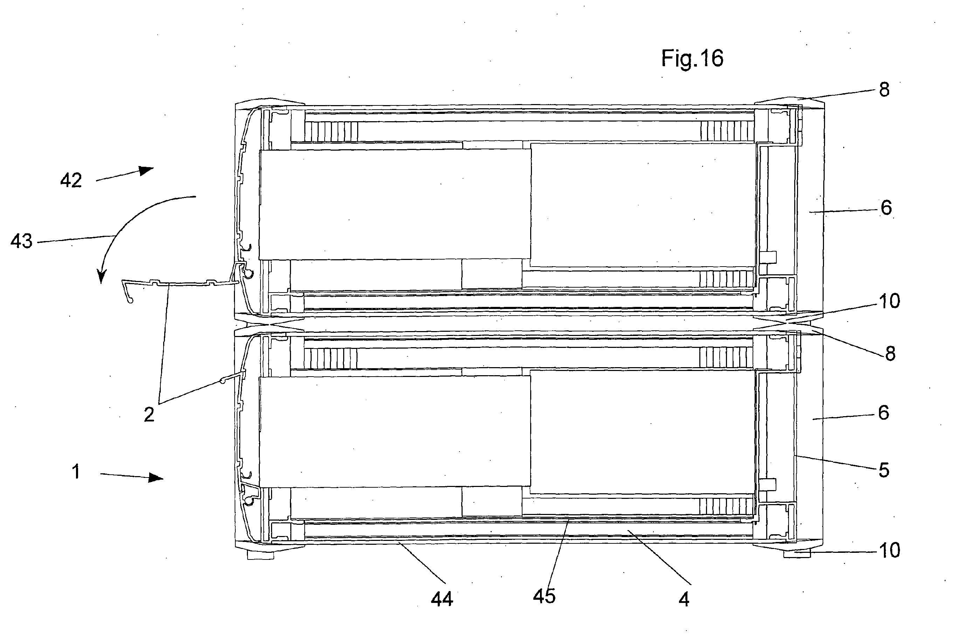

Werden die beiden Gehäuse übereinander gestapelt, wie dies beispielsweise in Figur 15 und 16 dargestellt ist, dann greift der Fuß 11 des unteren Abschlussstopfens 10 in die zugeordnete Ausnehmung des oberen Abschlussstopfens 8 ein.

Die Abschlussstopfen 8, 10 sind bevorzugt aus einem gummielastischen Material. Hierbei besteht der Vorteil, dass der den Boden des Eckverbinders 6 bildende, untere Abschlussstopfen 10 mit seinem Fuß 11 auf einer zugeordneten Aufstellfläche aufsitzt und eine gute Verschiebungssicherung bei guter Dämpfung gegen Erschütterungen gewährleistet.

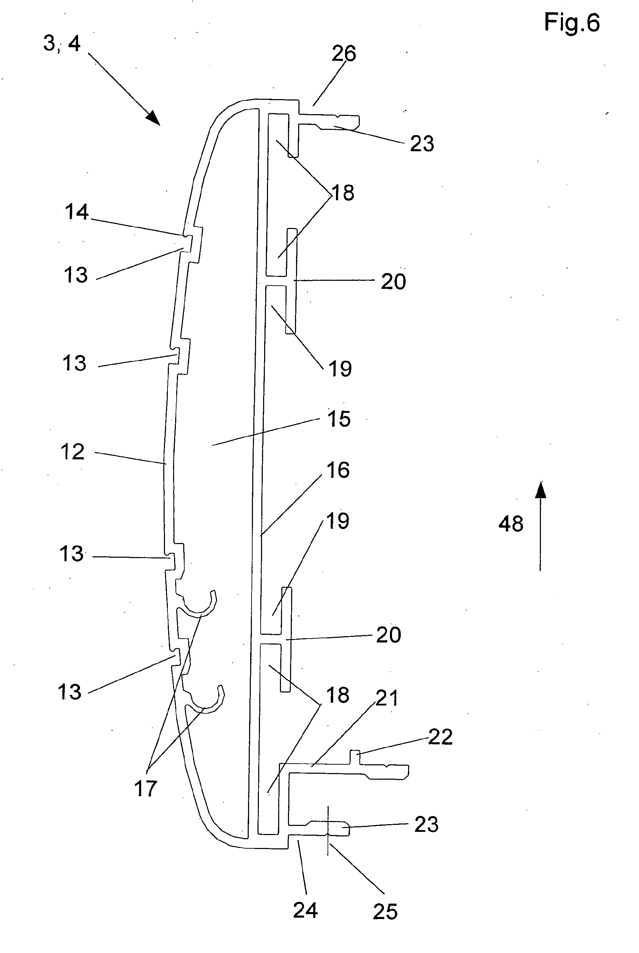

Die Figur 6 ist als erstes Ausführungsbeispiel ein für das Front- und Seitenwandprofil 3, 4 verwendetes Hohlprofil, dass im wesentlichen aus einer vorderen Profilwand (Außenwand 12) besteht, die zwischen sich eine Hohlkammer 15 bildet, die nach innen durch eine Innenwand 16 begrenzt ist.

In der Außenwand 12 sind eine Reihe von parallel zueinander angeordneten und einen gegenseitigen Abstand voneinander einnehmenden Rastnuten 13 angeordnet, wobei jede Rastnut in ihren oberen Bereich eine durchlaufende Rastnase 14 trägt.

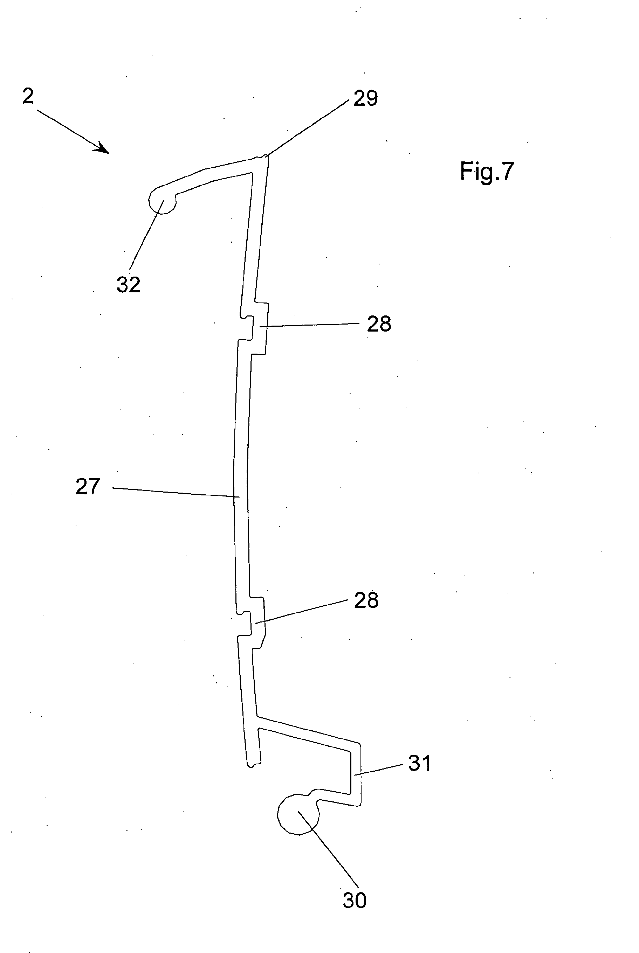

Im Innenraum der Hohlkammer 15 sind zwei übereinander und im gegenseitigen Abstand zueinander angeordnete, halboffene Lagerschalen 17 angeordnet, die zur Aufnahme der Lagerachse 30 der in Figur 7 dargestellten Frontklappe 2 dienen.

Im Vergleich der Figur 7 und der dort gezeigten Frontklappe 2 mit dem Profil nach Figur 6 ergeben sich verschiedene Einbaumöglichkeiten der Frontklappe.

Zunächst kann es vorgesehen sein, dass eine Frontklappe mit einer relativ großen Höhe verwendet wird, so dass die Lagerachse 30 auf der unteren Lagerschale 17 im Profil 3, 4 der Figur 6 eingebaut wird. Hierbei kann es dann vorgesehen sein, dass die Frontplatte mit ihrer oberen Rastnase 29 in eine der dort dargestellten Rastnuten 13 eingreift.

Eine weitere Einbaumöglichkeit ergibt sich dadurch, dass man die Lagerachse 30 auf der oberen Lagerschale 17 im Hohlprofil lagert, wodurch sich wiederum eine Reihe unterschiedlich hoher Frontplatten ergibt. Insgesamt kann es beispielsweise vorgesehen sein, dass vier unterschiedlich hohe Frontklappen in die Anordnung nach Figur 6 eingebaut werden. Die unterschiedliche Höhe der Frontklappen ergibt sich aus der Notwendigkeit, unterschiedlich breite Einschübe zu schaffen, um beispielsweise den Einbauraum für ein CD-ROM-Laufwerk, für ein Disketten-Laufwerk, für eine Festplatte und dergleichen zu gewährleisten.

Es wird bevorzugt, wenn das Profil der Frontklappe 2 gemäß Figur 7 wie das Außenwandprofil der Außenwand 12 nach Figur 6 ebenfalls leicht konvex gewölbt ist. Die Frontklappe schließt bündig an die Außenwand des Profils 3, 4 an und hierdurch wird ein besonders stimmiger, ästhetischer Gesamteindruck erzielt.

Bedingt durch die Tatsache, dass gemäß Figur 7 sich von der Lagerachse 30 aus eine mehrfach abgewinkelte Abkröpfung des Profils nach oben erstreckt und in den leicht konvexen Querschnitt des Klappenprofils 27 einmündet, ergeben sich Federeigenschaften für das Profil. Dass heißt, die Rastnase 29 weist eine Federeigenschaft in Bezug zu der mit ihr zusammenwirkenden Rastnase 14 im Bereich der Rastnut 13 an der Vorderseite des Profils 3, 4 auf.

Weil die Strangpressprofile mit sehr hoher Genauigkeit hergestellt werden können, ergibt sich ein toleranzarmes Spiel als Abstand zwischen der Lagerachse 30 und der Rastnase 29. Es ergibt sich eine ausgezeichnete Schließwirkung zwischen der Frontklappe 2 und der Vorderseite des Profils 3, 4, ohne dass es weiterer Schließeinrichtungen oder Rastungen bedarf.

Die am Klappenprofil 27 noch dargestellten Quernuten 28 dienen nur ästhetischen Zwecken, weil sie die an dem Profil 3, 4 angeordneten Rastnuten 13 optisch fortsetzen.

Die Figur 3 zeigt im übrigen noch, dass das Gehäuse von oben durch einen Deckel 7 abgeschlossen ist. Der Deckel wird bevorzugt aufgeschraubt. Es ist möglich, den Deckel auch über andere leicht lösbare Verschlüsse, nämlich Schnellverschlüsse mit dem nach oben offenen Gehäuse zu verbinden. Als Beispiel ist in Figur 3 dargestellt, dass die Abschlussstopfen 8, 10 entsprechend in den Innenraum eingreifende Lappen aufweisen, welche den Deckel 7 übergreifen und den Deckel damit halten.

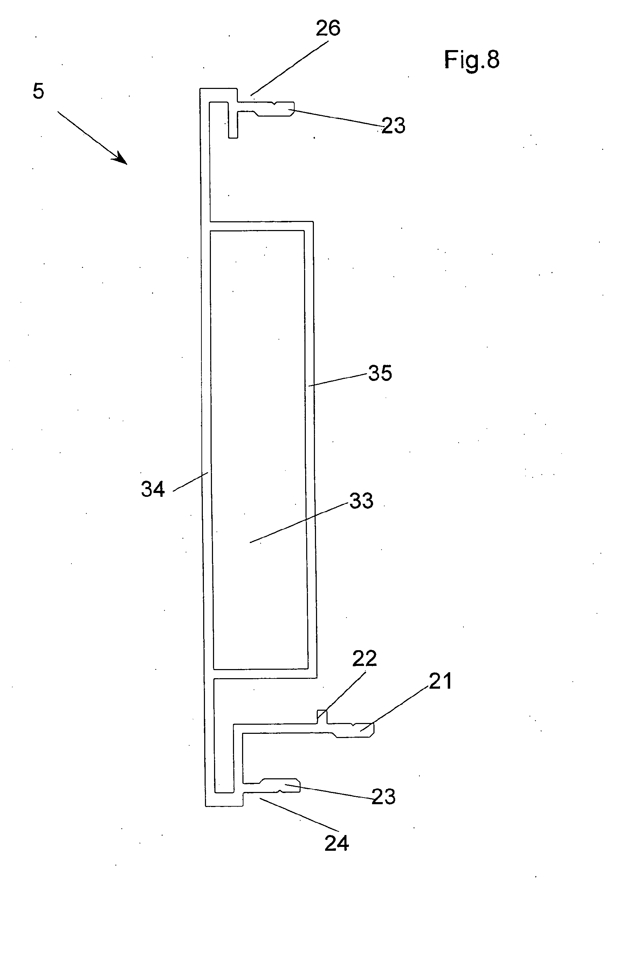

Die Figur 8 zeigt, dass auch das Rückwandprofil 5 entsprechend doppelwandig ausgebildet ist und aus einer Vorderwand 34 und einer in den Innenraum hinein ragenden Rückwand 35 besteht. Die beiden Wände weisen zwischen sich eine Hohlkammer 33 auf.

Es wird später noch dargestellt, dass die Vorderwand 34 mindestens teilweise entfernt werden kann, um so die Hohlkammer 33 nach außen hin zu öffnen.
In die Rückwand 35 werden entsprechende Schlitze eingefräst, durch welche in an sich bekannter Weise die Einschubplatinen hindurch ragen deren Anschlussbuchsen verdeckt in der Hohlkammer 33 liegen und damit gegen Beschädigung geschützt sind.

Der Vergleich der Figur 6 mit der Figur 8 zeigt die wesentlichen Vorteile bei der Verwendung der Eckverbinder.

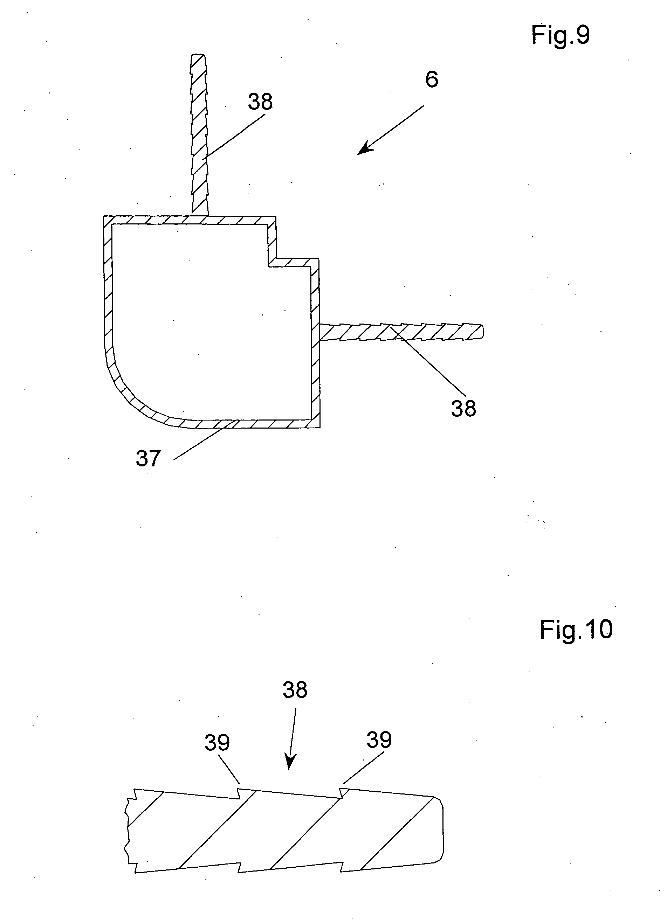

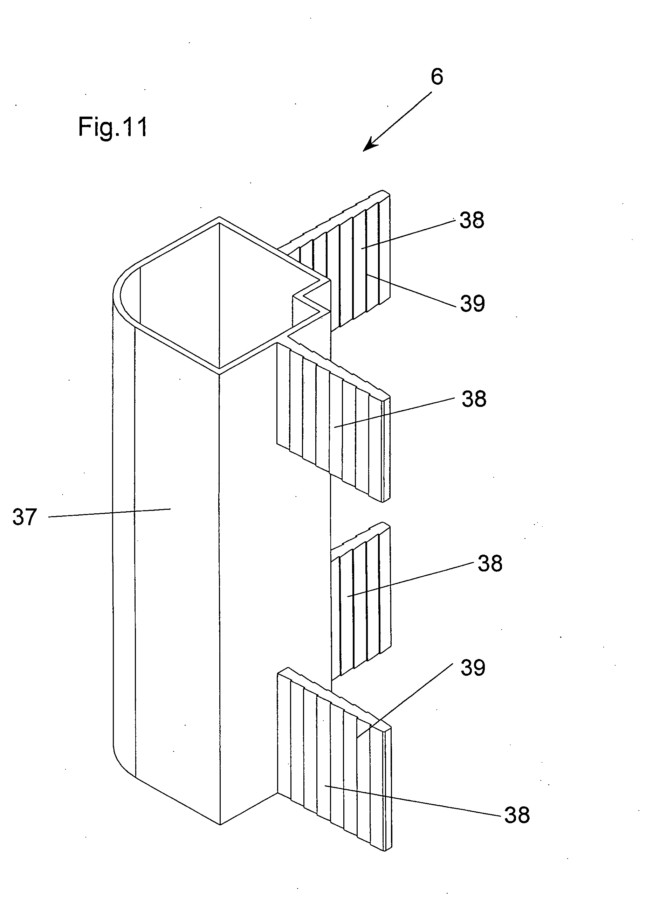

Ein Eckverbinder ist beispielsweise in den Figuren 9 bis 11 dargestellt. Er besteht bevorzugt aus einem Aluminiumstrangpressprofil, an Steckstege 38 angeformt sind. Gemäß Figur 10 weist jeder Stecksteg mehrere parallel zueinander angeordnete Widerhaken 39 auf.

Im Rohzustand sind die Steckstege 38 als durchlaufende Wandungen am Profil ausgebildet. Zur Ausbildung der Steckstege werden die Wandungsteile zwischen den Steckstegen entfernt, um so separate und voneinander getrennte, jedoch parallel zueinander angeordnete Steckstege 38 zu erhalten.

Die Steckstege 38 sind in zugeordneten, verschiedenartigen Einschubnuten 18, 19 der Profile 3-5 eingeschoben. Beispielsweise kann es vorgesehen sein, dass die unteren Steckstege 38 des jeweiligen Eckverbinders 6 in die zugeordnete Einschubnut 18 im unteren Bereich des Profils 3, 4, 5 eingesteckt sind.

Die untere Einschubnut ist durch einen unteren T-Steg 20 gebildet, der zwischen sich wiederum eine obere und eine untere Einschubnut 18, 19 ausbildet.

Ferner wird ein unterer Einschubraum dadurch ausgebildet, dass das jeweilige Profil 3, 4, 5 in einen unteren, erhöht über dem Boden und parallel hierzu angeordneten Profilansatz 21 übergeht, der im wesentlichen horizontal verläuft, wobei im Bereich dieses Profilansatzes 21 eine querverlaufende Rippe 22 angeordnet ist.

Parallel und im Abstand, sowie bodennah hierzu, ist ein paralleler Anschlagsteg 23 angeordnet, der einen unteren Aufnahmerahmen 24 für die Aufnahme eines nicht näher dargestellten Bodens darstellt.

Der Boden wird - wie oben anhand des Deckels geschildert wurde - mit einsprechend schnell lösbaren Verschlüssen in diesem Aufnahmeraum 24 befestigt.

Der Boden kann - ebenso wie der Deckel - aus verschiedenartigen Materialien bestehen. Bevorzugt wird ein Metall-, Kunststoff-, Aluminium- oder Aluminiumverbund-Material, letzteres kann auch sandwichartig zusammengesetzt sein.

Der Anschlagsteg 23 weist entsprechende Schraubkanäle 25 auf, so dass der Boden mit Hilfe von Schrauben angeschraubt werden kann, welche durch die Schraubkanäle 25 hindurch greifen.

Das für den Einbau bestimmte Mainboard 45 wird auf den umlaufenden Profilansatz 21 aufgesetzt, wobei die umlaufende Rippe 22 in zugeordnete Profilkanäle am Mainboard 45 eingreift.

Hierauf ist die jedoch lösbare Befestigung am Mainboard 45 nicht beschränkt. Es können selbstverständlich alle anderen lösbaren Verbindungen zwischen einem Mainboard 45 und dem zugeordneten Profilansatz 21 verwendet werden.

Wichtig ist, dass der Profilansatz 21 in den Innenraum des Gehäuses 1 hineinragt, so dass das Mainboard leicht nach oben in Pfeilrichtung 48 herausgenommen werden kann, wenn der Deckel 7 aus dem oberen Aufnahmerahmen 26 entfernt wurde.

Die verschiedenen, an dem Innenraum des Hohlprofils angeordneten T-Stege 20 bilden jeweils Einschuböffnungen für die Aufnahme der Steckstege 38 der Eckverbinder 6.

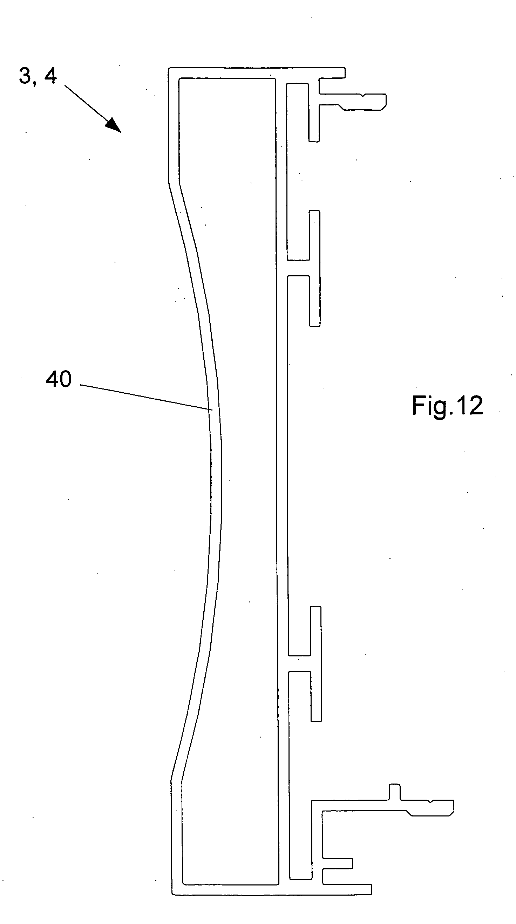

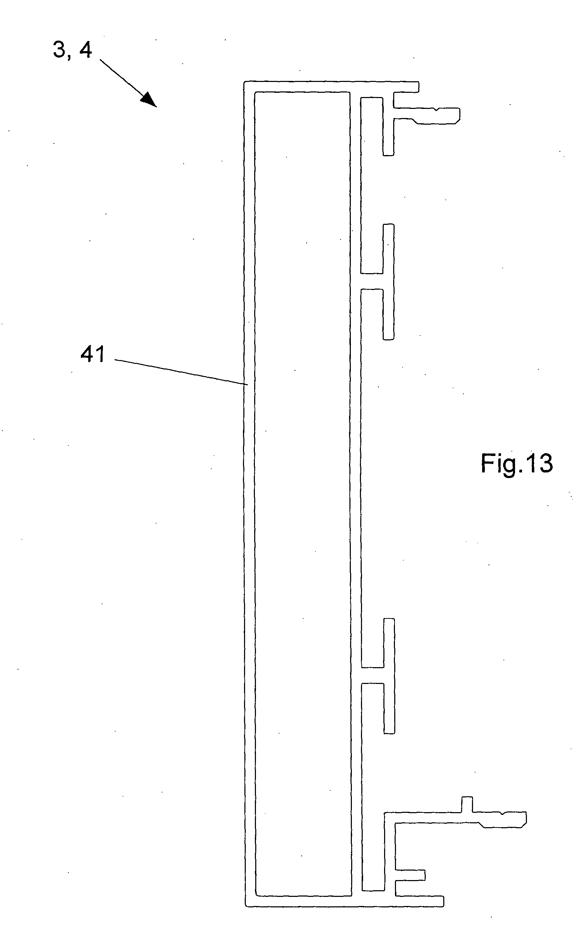

Die Figuren 12 und 13 zeigen im Vergleich zur Figur 6, dass auch die Frontwand 40, 41 des jeweiligen Profils 3-5 unterschiedlich gewölbt ausgebildet werden kann, um so unterschiedliche Gehäuseanmutungen zu gewährleisten. Es kann beispielsweise die Frontwand 41 gerade ausgebildet werden, um ein formal technisches Gehäuse auszubilden, wohingegen die Frontwand nach Figur 6 konvex gewölbt ist, um ein ästhetisch ansprechendes Gehäuse zu schaffen.

Selbstverständlich ist es nach Figur 12 ebenso vorgesehen, die Frontwand 40 konkav auszubilden, wodurch sich eine nach innen gerichtete Wölbung ergibt, an die auch eine zugeordnet konkav angepasste Frontklappe 2 anpassbar ist.

Diese Figuren 6, 12, 13 zeigen die universelle Anwendbarkeit des erfindungsgemäßen Hohlprofils.

Es soll noch erwähnt werden, dass die jeweilige Frontklappe 2 eine oben liegende Griffleiste 32 aufweist, die als Handhabe zur deren Betätigung dient.

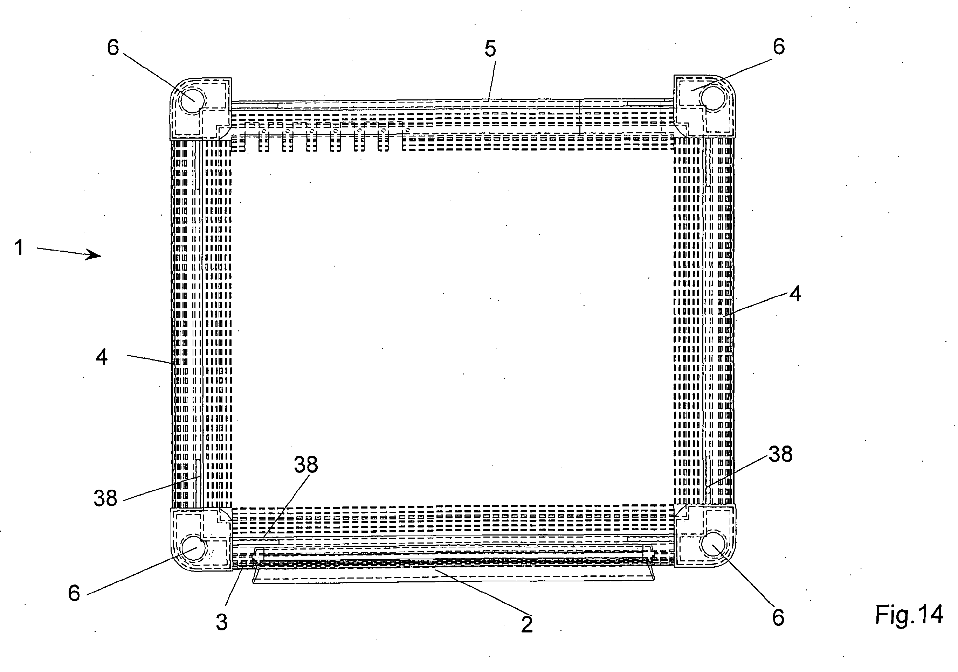

Die Figur 14 zeigt eine Zusammenstellungszeichnung des Gehäuses 1, wobei die einzelnen Profile 3-5 durch die Eckverbinder und deren Steckstege 38 miteinander verbunden sind. Die Figuren 15 und 16 zeigen ein Doppelgehäuse, welches aus einem unteren Gehäuse 1 gemäß den Figuren 1 bis 14 und einem oberen, darauf aufgesetzten, gleichen Gehäuse 42 besteht. Die Verbindung erfolgt über die vorher erwähnten Abschlussstopfen 8, 10, wobei der jeweilige Fuß 11 des Abschlussstopfens 10 in die zugeordnete Ausnehmung 9 des Abschlussstopfens 8 eingreift.

Figur 16 zeigt als Ausführungsbeispiel, dass die Frontklappe 2 des oberen Gehäuses 42 geöffnet ist. Sie ist in Pfeilrichtung 43 nach unten abgeschwenkt, während die Frontklappe 2 des unteren Gehäuses 1 geschlossen dargestellt ist.

Es ist als Beispiel dargestellt, dass im Abstand von dem unteren Boden 44 das Mainboard 45 eingebaut ist, das leicht lösbar auf den umlaufenden Rahmen aufgesetzt ist, der durch die umlaufenden Profileinsätze 21 gebildet ist.

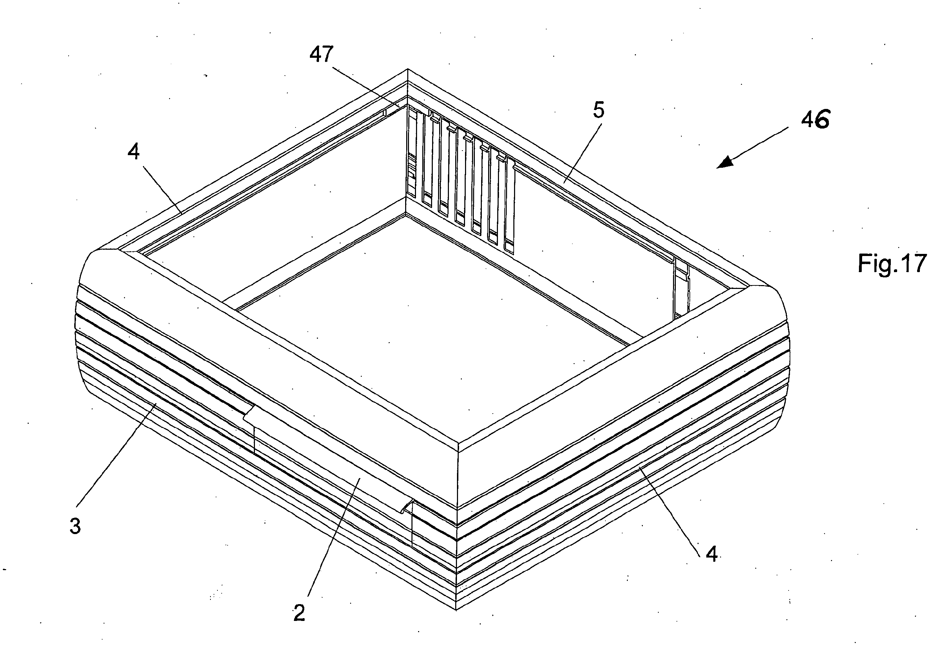

Schließlich zeigt die Figur 17 noch als weiteres Ausführungsbeispiel, dass ein Gehäuse 46 auch dadurch aufgebaut werden kann, dass die Eckverbinder 6 nicht außen angeordnet sind, sondern stattdessen innenliegende Eckverbinder 47 verwendet werden. Auf diese Weise stoßen die einander zugeordneten Kanten der Profile 3-5 unmittelbar aneinander und sind durch Gehrungsschnitte dicht aneinander gefügt. Es ergibt sich ein formschöner Außeneindruck, weil die Hohlprofile mit hoher Genauigkeit verarbeitet werden können und sich im Gehrungsbereich kein Spiel und keine sichtbare Fuge ergeben.

Selbstverständlich ist es möglich, im Gehrungsbereich Isolierelemente, wie z. B. Kunststoffscheiben oder dergleichen anzuordnen, die auch aus ästhetischen Gründen andersfarbig ausgebildet sein können. Ebenso kann die Stapelbarkeit des Gehäuses 46 nach Figur 17 dadurch erreicht werden, dass auf den oberen, umlaufenden Rahmen, entsprechende Abstandshalter aufgesetzt werden.

### Zeichnungslegende

- 1: Gehäuse
- 2: Frontklappe
- 3: Frontprofil
- 4: Seitenwandprofil
- 5: Rückwandprofil
- 6: Eckverbinder
- 7: Deckel
- 8: Abschlussstopfen (oben)
- 9: Ausnehmung
- 10: Abschlussstopfen (unten)
- 11: Fuß
- 12: Außenwand
- 13: Rastnut
- 14: Rastnase
- 15: Hohlkammer
- 16: Innenwand
- 17: Lagerschale
- 18: Einschubnut
- 19: Einschubnut
- 20: T-Steg
- 21: Profilansatz
- 22: Rippe
- 23: Anschlagsteg
- 24: Aufnahmeraum (Boden)
- 25: Schrankkanal
- 26: Aufnahmeraum
- 27: Klappenprofil
- 28: Quernut
- 29: Rastnase
- 30: Lagerachse
- 31: Abkröpfung
- 32: Griffleiste
- 33: Hohlkammer
- 34: Vorderwand
- 35: Rückwand
- 36: Schlitz
- 37: Hohlprofil
- 38: Stecksteg
- 39: Widerhaken
- 40: Frontwand
- 41: Frontwand
- 42: Gehäuse
- 43: Pfeilrichtung
- 44: Boden
- 45: Mainboard
- 46: Gehäuse
- 47: Eckverbinder
- 48: Pfeilrichtung

## Patentansprüche

1. Gehäuse aus Aluminium-Profilen zur Aufnahme elektrischer und elektronischer Bauteile, mit die Außenwand bildenden Kastenhohlprofilen, die im Eckbereich über Verbindungsstege miteinander verbunden sind, **dadurch gekennzeichnet, dass** mindestens die beiden Seitenwandprofile (4), das Rückwandprofil (5) und das Frontprofil(3) aus den kastenförmigen Aluminium-Hohlprofilen gebildet sind, die über zugeordnete Eckverbinder (6) zusammen gesteckt sind.

2. Gehäuse nach Anspruch 1, **dadurch gekennzeichnet, dass** die Eckverbinder (6) außen sichtbar am Gehäuse (1) angeordnet sind.

3. Gehäuse nach Anspruch 1, **dadurch gekennzeichnet, dass** die Eckverbinder (6) innenliegend am Gehäuse (1) und von außen nicht sichtbar angeordnet sind.

4. Gehäuse nach Anspruch 2 oder 3, **dadurch gekennzeichnet, dass** die Außenwand des Hohlprofils (2,3,4,5) konvex ausgebildet ist.

5. Gehäuse nach Anspruch 2 oder 3, **dadurch gekennzeichnet, dass** die Außenwand des Hohlprofils (2,3,4,5) konkav ausgebildet ist.

6. Gehäuse nach einem der Ansprüche 1 bis 5, **dadurch gekennzeichnet, dass** bei Anordnung von einer oder mehreren schwenkbarer Frontklappen (2) das Profil der Frontklappe (2) dem Profil der Außenwände (3,4,5) angepasst ist.

7. Gehäuse nach einem der Ansprüche 1 bis 6, **dadurch gekennzeichnet, dass** die Lagerschalen (17) für die Dreh- oder Schwenklagerung der schwenkbar in einer horizontalen Achse gelagerten Frontplatte (2) im Innenraum des Hohlprofils (3,4,5) angeordnet sind.

8. Gehäuse nach einem der Ansprüche 1 bis 7, **dadurch gekennzeichnet, dass** der Eckverbinder (6) stirnseitig von Abschlussstopfen 8, 10 verschlossen ist.

9. Gehäuse nach Anspruch 8, **dadurch gekennzeichnet, dass** die Stirnseite des Abschlussstopfens (10) einen daran angeformten Fuß (11) aufweist.

10. Gehäuse nach Anspruch 8, **dadurch gekennzeichnet, dass** Stirnseite des Abschlussstopfens (10) eine Ausnehmung (9) aufweist.

11. Gehäuse nach den Ansprüchen 9 und 10, **dadurch gekennzeichnet, dass** bei der Stapelung von Gehäusen (1) der Fuß (11) des oberen Abschlussstopfens (8) in die Ausnehmung (9) des unteren Abschlussstopfens (10) eingreift.

12. Gehäuse nach einem der Ansprüche 1 bis 11, **dadurch gekennzeichnet, dass** das Hohlprofil (3,4,5) aus einer vorderen Profilwand (Außenwand 12) besteht, die zwischen sich eine Hohlkammer (15) bildet, die nach innen durch eine Innenwand (16) begrenzt ist und dass in der Außenwand (12) eine Reihe von parallel zueinander angeordneten und einen gegenseitigen Abstand voneinander einnehmenden Rastnuten (13) angeordnet sind, wobei jede Rastnut in ihren oberen Bereich eine durchlaufende Rastnase (14) trägt.

13. Gehäuse nach einem der Ansprüche 1 bis 12, **dadurch gekennzeichnet, dass** im Innenraum der Hohlkammer (15) eine oder mehrere übereinander und im gegenseitigen Abstand zueinander angeordnete, halboffene Lagerschalen (17) angeordnet sind, die zur Aufnahme der Lagerachse (30) der Frontklappe (2) dienen.

14. Gehäuse nach einem der Ansprüche 1 bis 13, **dadurch gekennzeichnet, dass** die Vorderwand (34) des Rückwandprofils (5) mindestens teilweise entfernt ist, und dass in die verbleibende Rückwand (35) Schlitze und Öffnungen eingefräst sind, durch die Einschubplatinen, Stecker oder Dosen hindurch ragen.

15. Gehäuse nach einem der Ansprüche 1 bis 14, **dadurch gekennzeichnet, dass** der Eckverbinder (6) aus einem Aluminiumstrangpressprofil besteht, an dem Steckstege (38) angeformt sind.

16. Gehäuse nach Anspruch 15, d**adurch gekennzeichnet, dass** an den Stegstecken (38) des Eckverbinders (6) entgegen gesetzt zur Steckrichtung weisende Widerhaken (38) angeordnet sind.

17. Gehäuse nach Anspruch 15 oder 16, **dadurch gekennzeichnet, dass** die Steckstege (38) in zugeordnete Einschubnuten (18, 19) der Profile (3-5) eingeschoben sind.

18. Gehäuse nach einem der Ansprüche 1 bis 17, **dadurch gekennzeichnet, dass** ein unterer Einschubraum im Hohlprofil (3-5) für den Eingriff des jeweiligen Stecksteges (38) des Eckverbinders (6) ausgebildet ist, der in einen unteren, erhöht über dem Boden und parallel hierzu angeordneten horizontalen Profilansatz (21) übergeht, an dem eine querverlaufende, nach oben gerichtete Rippe (22) angeordnet ist, auf welche die Unterseite eines Mainboards (45) aufgesetzt ist.
